Europäisches Patentamt

European Patent Office

Office européen des brevets

(11) Publication number: **0 558 093 A2**

# EUROPEAN PATENT APPLICATION

(21) Application number: 93103502.6

(22) Date of filing: 29.03.88

(51) Int. Cl.⁵: **H01L 39/24**

This application was filed on 04 - 03 - 1993 as a divisional application to the application mentioned under INID code 60.

(30) Priority: **31.03.87 JP 80028/87**
**09.10.87 JP 254969/87**

(43) Date of publication of application:
**01.09.93 Bulletin 93/35**

(60) Publication number of the earlier application in accordance with Art.76 EPC: **0 285 108**

(84) Designated Contracting States:
**DE FR GB**

(71) Applicant: **SUMITOMO ELECTRIC INDUSTRIES LIMITED**
**No. 15, Kitahama 5-chome, Higashi-ku**
**Osaka-shi, Osaka 541(JP)**

(72) Inventor: **Yamauchi, Kazuhisa, c/o Osaka Works of Sumitomo**
**Elect. Ind. Ltd, 1-3, Shimaya 1-chome,**
**Konohana-ku**
**Osaka(JP)**
Inventor: **Ohmatsu, Kazuya, c/o Osaka Works of Sumitomo**
**Elect. Ind. Ltd, 1-3, Shimaya 1-chome,**
**Konohana-ku**
**Osaka(JP)**
Inventor: **Ishida, Tetsuya, c/o Itami Works of Sumitomo**
**Elec. Ind., Ltd, 1-1, Koyakita 1-chome**
**Itami-shi, Hyogo-ken(JP)**
Inventor: **Gotoh, Tomoji, c/o Itami Works of Sumitomo**
**Elec. Ind., Ltd, 1-1, Koyakita 1-chome**
**Itami-shi, Hyogo-ken(JP)**
Inventor: **Yazu, Syuji, c/o Itami Works of Sumitomo**
**Elec. Ind., Ltd, 1-1, Koyakita 1-chome**
**Itami-shi, Hyogo-ken(JP)**
Inventor: **Jodai, Tetsuji, c/o Itami Works of Sumitomo**
**Elec. Ind., Ltd, 1-1, Koyakita 1-chome**
**Itami-shi, Hyogo-ken(JP)**

(74) Representative: **KUHNEN, WACKER & PARTNER**
**Alois-Steinecker-Strasse 22 Postfach 1553**
**D-85315 Freising (DE)**

(54) Method of producing superconducting wire.

(57) The present invention relates to a method of producing a superconducting wire and provides a method of producing a superconducting wire and further a composite superconducting wire consisting of a usual conductor and a superconductor having a high superconducting critical temperature capable of being applied in remarkably many fields such as an electric power field, such as MHD generation of electricity, transmission of electric power and storage of electric power, power field, such as magnetic levitation train and electro-magnetic propelling ship, and instrumental field, such as NMR, $\pi$-meson medical treatment and high-energy physics experimental apparatus as a supersensitive sensor for a magnetic field, microwave, radio-active beam and the like.

EP 0 558 093 A2

# F I G. 1

## (a)

1

## (b)

1'

## (c)

3

1'

2

## (d)

1'

2

## (e)

1'

2

[Field of the Invention]

The present invention relates to a method of producing a superconducting member, in particular to a method of producing a superconducting wire and further a superconducting wire consisting of a usual conductor and a superconductor capable of effectively utilizing a superconducting material having a high superconducting critical temperature.

[Prior Art and Problems to be Solved]

A substance exhibits a complete diamagnetism under the superconducting phenomenon and a potential difference disappears even though a definite stationary current passes through an inside of the substance. So, various kinds of application of the superconductor as a transmission medium without showing any loss of electric power have been proposed.

That is to say, the fields of the superconductor include remarkably many fields such as an electric power field, such as MHD generation of electricity, transmission of electric power and storage of electric power, power field, such as magnetic levitation train and electro-magnetic propelling ship, and instrumental field, such as NMR, $\pi$-meson medical treatment and high-energy physics experimental apparatus as a supersensitive sensor for a magnetic field, microwave, radio-active beam and the like.

In addition, the superconductor has been expected as an art capable of not only reducing a consumption of electric power but also realizing an element, which is remarkably speedy in action, also in the field of electronics represented by a Josephson's devices.

The superconductivity has been a phenomenon which is observed only at superlow temperatures. That is to say, a remarkably low temperature of 23.2 K has been said to be the limit of the superconducting critical temperature even for $Nb_3Ge$, which has been said to be the conventional superconducting material having the highest superconducting critical temperature Tc, for a long time.

Accordingly, the superconducting material has been cooled to Tc or less using liquid helium having a boiling point of 4.2 K to realize the superconducting phenomenon. However, the use of liquid helium has led to a remarkably increased technical burden and burden in cost due to a cooling facility including a liquefying device, and thus the realization of superconducting technique has been hindered.

It has, however, been recently reported that a sintered body comprising an oxide of elements of the group IIa or IIIa in the periodic table can be a superconductor having a remarkably high Tc, and thus the realization of the superconducting technique using a non-low temperature superconductor is going to be rapidly promoted. Composite oxides having a so-called pseudo-perovuskite type crystalline structure such as $[La, Ba]_2CuO_4$ or $[La, Sr]_2CuO_4$, which seem to have an orthorhombic structure and the like similar to the crystalline structure of perovuskite type oxides, have been already reported. Tc of 30 to 50 K remarkably high in comparison with that of the conventional superconducting materials has been observed for these substances. In addition, also Tc of 70 K or more has been reported for superconducting materials formed of oxides of Ba, Y and Cu.

However, since these superconducting materials are obtained in the form of sintered body at present, that is, they are produced by sintering molded products having an appointed length in a lump, a method of continuously producing a long object, such as a wire, has not been developed. In addition, the superconducting material obtained in the form of sintered body is remarkably fragile, so that the superconducting material is difficult to mold in many cases.

In addition, a method, in which the superconducting wire is preliminarily produced and then coated with a usual conductor, has been used as a method of producing the composite wire consisting of the usual conductor and the superconductor.

However, according to such method, the process of producing the superconducting wire and the process of coating the superconducting wire with the usual conductor are required, so that such method is not efficient.

Thus, it is an object of the present invention to solve the above described points of problem of the conventional arts, whereby providing a novel method of continuously producing a superconducting material having a high Tc in the form of a wire highly stable in superconducting characteristic and superior in maintenance of shape.

It is another object of the present invention to provide a method of producing a composite wire comprising a superconductor in one step.

3

EP 0 558 093 A2

[Measures for Solving the Problems]

In order to achieve the first object of the present invention, the present invention at first provides a method of producing a superconducting wire, characterized by comprising a first step of continuously pressing a long plate material into a pipe having a U-shaped section; a second step of continuously supplying an inner side of the resulting pipe having a U-shaped section with raw material powders; a third step of turning said pipe having a U-shaped section into a pipe having an O-shaped section and subjecting butt portions of said plate material to the seam welding; a fourth step of subjecting the resulting pipe with the raw material powders housed therein to the drawing; and a fifth step of sintering the resulting pipe with the raw material powders housed therein by heating collectively.

And, according to the preferred embodiment of the present invention, said raw material powders preferably include mixture powders formed of oxides, nitrides, fluorides, carbonates, nitrates, oxalates or sulfates of one kind of element $\alpha$ selected from elements of the group IIa in the periodic table, one kind of element $\beta$ selected from elements of the group IIIa in the periodic table and one kind of element $\gamma$ selected from elements of the groups Ib, IIb, IIIb, IVa and VIIIa in the periodic table or powders of sintered composite oxides obtained by sintering said mixtures and then pulverizing them.

In addition, in order to achieve another object, according to the present invention, a band conductor is continuously supplied to bend in a flume-like shape and then the resulting bent concave portion is supplied with the oxide superconducting materials. Subsequently, said conductor is bent, so that a desired gap may be left between both side edges thereof, to envelop said material followed by the sintering process to sinter said material and then roll until the desired diameter.

[Operation]

The method of producing a superconducting material according to the present invention is mainly characterized by that a series of steps [step of producing a pipe - step of molding - step of drying/removing binders - step of sintering] are continuously carried out. In other words, according to the present invention, the process can be simplified and continuously carried out as a whole by the step of turning the plate material into the pipe and the supply of the raw material powders at the same time.

That is to say, as mentioned later, the metallic pipe having a small diameter preferably used as the material of the superconducting wire is produced generally in the form of electric welded tube. This step, as concretely mentioned later, is carried out by at first turning the plate material into the pipe having a U-shaped section by pressing and then the pipe having an O-shaped section followed by subjecting the butt portions to the seam welding. In these steps, the pipe does not form a closed section until after the seam welding. In particular, after the plate material is turned into the pipe having a U-shaped section, its portion corresponding to a side of the pipe is greatly opened. Accordingly, prior to the time when the pipe having a U-shaped section is turned into the pipe having an O-shaped section the former can be continuously supplied with the raw material powders from the side thereof.

Accordingly, according to the method of the present invention, the raw material powders are already housed in the pipe at the time when the plate material is formed as the pipe having a small diameter. Consequently, the material formed in a thin wire-like shape can be sintered to produce the superconducting wire by subjecting the pipe with the raw material powders housed therein to the drawing and heating treatment.

According to the method of the present invention, as concretely mentioned later, the steps from the step of molding to the step of sintering can be continuously carried out, so that an appointed quantity of raw materials can be produced in the form of continuous product, whereby the long member, such as electric power transmission medium, can be advantageously produced.

In addition, it goes without saying that in these steps all of the conventional techniques accumulated in the production of electric welded tubes can be applied, that is, the plate material is turned into a pipe having a C-shaped section (by the use of a crimping press) before it is turned into the pipe having a U-shaped section or the butt surfaces formed when the pipe having a U-shaped section is formed are ground to expose the activated surface.

In addition, as mentioned later, some materials, of which the pipe is formed, bring about chemical reactions with composite oxide superconducting materials. In this case, it is preferable that the surface of the plate material is subjected to the surface treatment, for example the surface of the plate material is previously coated with stable substances.

The superconducting wire produced according to the present invention is a sintered wire with a sheath member having superior superconducting characteristics incidental to composite oxide sintered bodies.

4

And, the sheath member functions as a support member, so that the superconducting wire produced according to the present invention has also a high mechanical strength. In addition, if the sheath member is formed of conductors, the sheath member functions as a current by-path and a radiating passage when quenched.

In view of these working methods and the desired characteristics, a plate material formed of one kind selected from the group consisting of stainless steel, Cu, Ag, Au, Pt, Pd, Rh, Fe, Pb, Sn, Cd, Ti, W, Mo, Zr, Hf, Ta and Nb or alloys thereof as the plate material, of which the pipe is formed, but it is not limited to them. In addition, Cu, Fe and the like are advantageous in easy workability and inexpensiveness, stainless steel and Pt being advantageous in chemical stability to have no chemical influence upon the superconducting material, and further Ag, Pd, Rh and the like being advantageous as the sheath member of the superconducting material, for which in particular the control of oxygen-concentration is required, since some of their oxides emit oxygen due to the change of temperature. The material of these sheath members should be suitably selected depending upon the use of the superconducting material and the like.

In addition, the method according to the present invention can be widely used as a method of producing long sintered products but in particular the use of composite oxide sintered bodies expressed by the general formula $\alpha_w\,\beta_x\,\gamma_y\,\delta_z$, wherein an element $\alpha$ is one kind selected from elements of the group IIa in the periodic table; an element $\beta$ being one kind selected from elements of the group IIIa in the periodic table; an element $\gamma$ being one kind selected from elements of the groups Ib, IIb, IIIb and VIIIa in the periodic table; $\delta$ being O; w, x, y and z being a number meeting $1 \leq w \leq 5$, $1 \leq x \leq 5$, $1 \leq y \leq 15$ and $1 \leq z \leq 20$, respectively, as the superconducting material leads to a more advantageous effect. In addition, said composite oxides include in particular composite oxides, such as Ba - Y - Cu, Ba - Ho - Cu, Sr - La - Cu or Ba - Dy - Cu, exhibiting particularly superior characteristics. These composite oxides seem to have a so-called pseudo-perovuskite type crystalline structure including oxygen vacancies such as an orthorhombic structure. Such superconducting materials can be effectively used as the transmission medium of electric power and the like by turning them into a long superconductor according to the present invention.

It is desired in the sintering step of these composite oxide powders that the sintering temperature has an upper limit at a melting point of the sintered body and a difference between the sintering temperature and the melting point of the sintered body is 100°C or less. Because if the sintering temperature is lower than the above described range, the sintering reaction of the sintered body powders is not made progress and the strength of the resulting sintered body is extraordinarily reduced while if the sintering temperature exceeds the above described range, the liquid phase is produced during the sintering step to lead to the melting or decomposition of the sintered body, whereby remarkably lowering Tc of the sintered body.

In addition, according to the discovery by the present inventors, the addition of powdery oxides, carbonates, sulfates or nitrates of at least one kind of element selected from the group consisting of V, Nb, Ta, Mo, W, Ti, Cr, Mn, Ga, In, Cd, Sn, Tl, Pb and Zn to the element $\gamma$ at an atomic ratio of about 0.01 to 0.15 leads to more superior superconducting characteristics. In addition, it is preferable that the raw material powders have a particle diameter of 10 microns or less. The pulverization of the raw material powders realizes the effective sintering reaction, the uniform structure and an increase of an intercrystalline surface area playing an important function for the superconducting characteristics.

The present invention is below concretely described with reference to the preferred embodiments but the following preferred embodiments are merely illustrative. The technical scope of the present invention is not limited by them.

The drawings are below briefly described.

Fig. 1(a) to (e) is a progress chart showing every step in the method of producing the superconducting material according to EXAMPLE 1 of the present invention; and

Fig. 2 is a progress chart showing the method of producing the superconducting wire according to EXAMPLE 2 of the present invention.

EXAMPLE 1

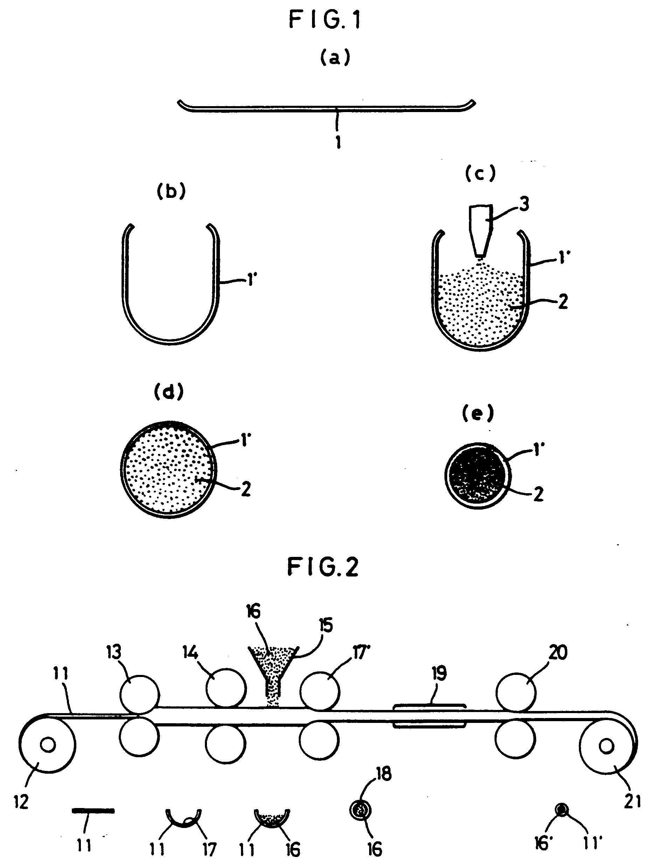

At first, the Cu plate 1 was turned into a pipe having a C-shaped section, as shown in Fig. 1(a), and then heated in air to oxidize the surface thereof. Then, side edge surfaces of the plate 1 were subjected to the grinding to expose the activated surfaces and adjust the shape of the end surfaces Although merely the end surfaces in the direction of length of the plate 1 were ground in the present preferred embodiment, all side end surfaces may be ground and an endless pipe may be produced by connecting the plates with each other in turn.

Successively, this plate was turned into the pipe 1' having a U-shaped section by means of a forming roll, as shown in Fig. 1(b). Then, the inside of the pipe 1' having a U-shaped section was continuously supplied with the raw material powders 2 through the nozzle 3, as shown in Fig. 1(c).

The raw material powders 2 supplied here are powders of composite oxide sintered bodies obtained by preliminarily sintering the mixture comprising powders of $BaCO_3$, $Y_2O_3$ and $CuO$ having the purity of 3N or more and an average particle diameter of 5 microns or less, so that the composition after sintering may become $Ba_2YCu_3O_7$, in air at 900°C for 24 hours and then roughly pulverizing the resulting caked powders followed by pulverizing until 4 microns in a ball mill made of high purity zirconia and repeating this process further three times.

Next, the pipe 1' having a U-shaped section with the raw material powders 2 housed therein was turned into a pipe having an O-shaped section by means of the forming roll and the butt surfaces were welded by the TIG welding to obtain the Cu pipe 1' with the raw material powders housed therein, as shown in Fig. 1-(d).

Subsequently, the Cu pipe 1' with the raw material powders housed therein was reduced in diameter and drawn by means of a die disposed in a tandem relation to the forming roll line, as shown in Fig. 1(e).

The resulting wire was cut in 5 pieces having a length of 1 m and sample numbers ① to ⑤.

In addition, the above described wire was subjected to the intermediate annealing in an atmosphere of $N_2$ gas at 700°C for 1 hour and then reduced in diameter and drawn again by means of a reducing die to obtain a wire. Also this wire was cut in 5 pieces having a length of 1 m and sample numbers ⑥ to ⑩.

These samples ① to ⑩ were subjected to heat treatments under the conditions shown in the following Table 1 to obtain products.

Although the samples all were heated in an atmosphere of $N_2$ gas at 900°C, the heating time was changed. In addition, the samples ④ to ⑨ were heated and cooled and then heated at 700°C for 10 hours again followed by cooling at a rate of 10°C/min. In addition, the samples ⑤, ⑩ were heated also at 700°C for 10 hours and then cooled at a rate of 50°C/min.

Also the measured results of superconducting characteristics of each sample are shown in Table 1.

**Table 1**

| Sample No. | Heating time (hr) | Tc (K) | Tci (K) |
|:---:|:---:|:---:|:---:|
| ① | 0.5 | 89 | 67 |
| ② | 6 | 87 | 72 |
| ③ | 12 | 89 | 84 |
| ④ | 12 | 91 | 82 |
| ⑤ | 12 | 90 | 83 |
| ⑥ | 0.5 | 86 | 73 |
| ⑦ | 6 | 88 | 79 |
| ⑧ | 12 | 95 | 91 |
| ⑨ | 12 | 94 | 89 |
| ⑩ | 12 | 97 | 93 |

The critical temperature Tc and the temperature Tci, at which the electric resistance becomes completely zero, were measured by the direct current four-probe method within a cryostat with fitting electrodes to both ends of the sample with an electrically conductive Ag paste according to the usual method. The temperature was measured by means of a calibrated Au(Fe) - Ag thermocouple. The change in resistance was observed with rising the temperature little by little.

EXAMPLE 2

As shown in Fig. 2, a band copper wire 11 is continuously drawn from a reel 12 and passed over forming rolls 13, 14 to bend said copper wire 11 in a flume-like shape.

After passing over the forming rolls 13, 14, the bent concave portion 17 of the copper wire 11 is supplied with powdery oxide superconducting materials 16 from a feeder 15.

Subsequently, the copper wire is further bent in a forming roll 17' to approach both end edges thereof to each other and envelop said materials 16 with leaving a slight gap 18. This gap 18, which does not drop the materials 16 and can sufficiemtly supply the materials 16 housed in the copper wire with oxygen in the subsequent sintering step, is sufficient.

Said materials 16 are sintered in a sintering firnace 19 with supplying them with oxygen. After sintering, the copper wire 11 is passed over a rolling roll 20 to draw a clad copper wire 11' and sintered bodies 16' housed in said clad copper wire 11' integrally until the desired diameter followed by rolling up on a reel 21.

In addition, in order to completely turn the sintered bodies 16' housed in said clad copper wire 11' into a solid solution, the clad copper wire 11' housing the sintered bodies 16' may be subjected to an additional heat treatment before it is rolled up on the reel 21.

In addition, although powdery oxide superconducting materials are used in the above described EXAMPLE, molten oxide superconducting materials may be supplied in the bent concave portion with chilling to coagulate.

In addition, aluminium, silver or alloys thereof can be used as the conductor in addition to the above described copper. Besides, every oxide superconducting material comprising any one of Ca, Ba and Sr, any one of Y, Sc and lanthanoides, any one of Cu, Ag and Au and any one of O, F, N and C can be used.

EXAMPLE 3

A stainless steel plate having a width of 25 mm, a length of 1,000 mm and a thickness of 1 mm was bent to form a flume having a U-shaped section and an opened portion of 5 mm wide.

On the other hand, a mixture comprising powders of $Bi_2O_3$, $SrCO_3$, $CaCO_3$ and $CuO$ having an average particle diameter of 5 microns or less, so that the composition may become $Bi_4Sr_3Ca_3Cu_4O_x$ after the baking process, was preliminarily baked in air at 800°C for 5 hours and then cooled followed by melting at 1,100°C in a platinum crucible.

The resulting flume having a U-shaped section was closed at both ends thereof and then heated at 800°C followed by supplying an inside thereof with said molten mixture.

Subsequently, the flume was subjected to a heat treatment in air at 840°C for 5 hours.

The critical temperature of the resulting heat treated product was measured by the same method as in EXAMPLE 1 with the results that Tc was 121 K and Tci was 80 K. In addition, this superconducting wire did not produce any gap between the flume and the superconductor even after the heat cycle of room temperature-liquid nitrogen was repeated 100 times.

[Effects of the Invention]

As above described in detail, according to a method of producing a superconducting wire of the present invention, a long composite oxide superconducting material having a high critical temperature can be continuously produced. Thus, the superconducting material can be actually utilized as for example a transmission medium of electric power and the like. In addition, a long superconducting product produced according to the present invention has a metallic sheath member therearound, so that this metallic sheath member functions as a mechanical support member and a by-path of electric current when quenched.

In addition, the present invention consists in that the bent concave portion of the conductor bent in flume-shape is supplied with the oxide superconducting materials and the sintering is carried out under the condition that the materials are enveloped in the conductor so as to form a minute gap between both end edges of the conductor, so that the sintering can be carried out with adjusting the concentration of oxygen.

Accordingly, the present invention exhibits an effect in that the composite wire comprisinf the conductor and the superconductor can be produced by a single continuous process.

**Claims**

1. A method of producing a superconducting wire, characterized by comprising a first step of continuously turning a long plate material into a pipe having a U-shaped section; a second step of continuously supplying an inside of the resulting pipe having a U-shaped section with raw material powders; a third step of turning said pipe having a U-shaped section into a pipe having an O-shaped section and subjecting butt portions of said plate material to the seam welding; a fourth step of drawing the resulting pipe with the raw material powders housed therein; and a fifth step of heating collectively to sinter said raw material powders.

2. A method of producing a superconducting wire as set forth in Claim (1), characterized by that said raw material powders are any one of mixture powders formed of oxides, nitrides, fluorides, carbonates, nitrates, oxalates or sulfates of one kind of element $\alpha$ selected from elements of the group IIa in the periodic table, one kind of element $\beta$ selected from elements of the group IIIa in the periodic table and one kind of element $\gamma$ selected from elements of the groups Ib, IIb, IIIb, IVa and VIIIa in the periodic table and powders of baked composite oxides obtained by baking said mixtures and pulverizing them.

3. A method of producing a superconducting wire as set forth in Claim (2), characterized by that said baked composite oxides are expressed by the general formula $\alpha_w \, \beta_x \, \gamma_y \, \delta_z$, wherein an element $\alpha$ is one kind selected from elements of the group IIa in the periodic table; an element $\beta$ being one kind selected from elements of the group IIIa in the periodic table; an element $\gamma$ being one kind selected from elements of the groups Ib, IIb, IIIb and VIIIa in the periodic table; $\delta$ being O; w, x, y and z being a number meeting $1 \leq w \leq 5$, $1 \leq x \leq 5$, $1 \leq y \leq 15$ and $1 \leq z \leq 20$, respectively.

4. A method of producing a superconducting wire as set forth in any one of Claims (1) to (3), characterized by that said plate material is turned into a pipe having a C-shaped section before it is turned into a pipe having a U-shaped section.

5. A method of producing a superconducting wire as set forth in any one of Claims (1) to (4), characterized by that at least an inner surface of said plate material is subjected to a surface treatment prior to said second step.

6. A method of producing a superconducting wire as set forth in Claim (5), characterized by that said surface treatment is a treatment of forming an oxidized film on a surface of said plate material.

7. A method of producing a superconducting wire as set forth in any one of Claims (1) to (6), characterized by that said plate material is turned into the pipe having a U-shaped section by means of a forming roll.

8. A method of producing a superconducting wire as set forth in any one of Claims (1) to (7), characterized by that said butt surfaces of the plate material is subjected to the grinding to expose an activated surface prior to said third step.

9. A method of producing a superconducting wire as set forth in any one of Claims (1) to (8), characterized by that said seam welding is carried out by the TIG welding in said third step.

10. A method of producing a superconducting wire as set forth in Claim (9), characterized by that said TIG welding is carried out in an atmosphere of $N_2$ gas.

11. A method of producing a superconducting wire as set forth in any one of Claims (1) to (10), characterized by that said fourth step is carried out by means of a reducing die.

12. A method of producing a superconducting wire as set forth in any one of Claims (1) to (11), characterized by that the drawing process is carried out plural times repeatedly at a reduction in area of 30 % or less in said fourth step.

13. A method of producing a superconducting wire as set forth in any one of Claims (1) to (12), characterized by that said plate material is formed of one kind of metal selected from the group consisting of stainless steel, Cu, Ag, Au, Pt, Pd, Rh, Fe, Pb, Sn, Cd, Ti, W, Mo, Zr, Hf, Ta and Nb or allots thereof.

14. A method of producing a superconducting wire as set forth in any one of Claims (1) to (13), characterized by that powders of oxides, carbonates, sulfates or nitrates of at least one kind of metal selected from the group consisting of V, Nb, Ta, Mo, W, Ti, Cr, Mn, Ga, In, Cd, Sn, Tl, Pb and Zn are additionally added to said raw material powders as additives.

15. A method of producing a superconducting wire as set forth in Claim (14), characterized by that said additives are added at an atomic ratio of 0.01 to 0.15 based on one mol of said element .

16. A method of producing a superconducting wire as set forth in any one of Claims (1) to (15), characterized by that said raw material powders have particle diameters of 30 microns or less.

17. A method of producing a superconducting wire as set forth in any one of Claims (1) to (16), characterized by that the sintering is carried out with the melting point of the material having the lowest melting point of said raw material powders as an upper limit so that a difference between the sintering temperature and said melting point may be 100°C or less in said fifth step.

18. A method of producing a superconducting wire as set forth in any one of Claims (1) to (17), characterized by that the sintered raw material powders are gradually cooled at a rate of 15°C/min or less in said fifth step.

19. A method of producing a superconducting wire as set forth in any one of Claims (1) to (18), characterized by that said element $\alpha$ (but the element $\alpha$ is above defined) is Ba, said element $\beta$ (but the element $\beta$ is above defined) being Y, and said element $\gamma$ (but the element $\gamma$ is above defined) being Cu.

20. A method of producing a superconducting wire as set forth in any one of Claims (1) to (18), characterized by that said element $\alpha$ (but the element $\alpha$ is above defined) is Ba, said element $\beta$ (but the element $\beta$ is above defined) being Ho, and said element $\gamma$ (the element $\gamma$ is above defined) being Cu.

21. A method of producing a superconducting wire as set forth in any one of Claims (1) to (18), characterized by that said element $\alpha$ (the element $\alpha$ is above defined) is Ba, said element $\beta$ (the element $\beta$ is above defined) being Dy, and said element $\gamma$ (the element $\gamma$ is above defined) being Cu.

# FIG.1

## (a)

## (b)

## (c)

## (d)

## (e)

# FIG.2